# DEMANDE DE BREVET EUROPEEN

(11) **EP 3 823 166 A1**
(43) Date de publication de la demande: **19.05.2021**
(21) Numéro de dépôt: 20207569.3
(22) Date de dépôt: 13.11.2020
(51) Int. Cl.: H03K 17/22, G06F 1/24, H03K 3/356

(54) **DISPOSITIF POUR DÉLIVRER UN SIGNAL PASSANT D'UN PREMIER ÉTAT À UN DEUXIÈME ÉTAT**

(30) Priorité: 13.11.2019 FR 1912669
(71) Demandeur: Idemia Identity & Security France, 92400 Courbevoie (FR)
(72) Inventeur: BRUDER, Bertrand, 92400 Courbevoie (FR); CROGUENNEC, Alexandre, 92400 Courbevoie (FR)
(74) Mandataire: Regimbeau

(57) **Abrégé**

Dispositif (1) pour délivrer un signal (por_out) passant d'un premier état à un deuxième état, comprenant : un circuit primaire (4) générant un signal primaire (por_ana); et un circuit secondaire (6) configuré pour :
- lorsque le signal primaire (por_ana) est initialisé dans le deuxième état lors de la mise sous tension, initialiser un compteur annulaire (16) à une valeur aléatoire comprise dans une séquence finie comprenant une valeur de référence (INIT),
- changer la valeur du premier compteur annulaire (16) en parcourant la première séquence finie de manière circulaire,
- délivrer sur une sortie (3) : i) un signal secondaire dans le premier état, lorsque la valeur du premier compteur est différente de la valeur de référence (INIT), et ii) le signal primaire (por_ana), lorsque la valeur du premier compteur est égale à la valeur de référence (INIT).

## Description

### DOMAINE DE L'INVENTION

La présente invention concerne un dispositif pour délivrer un signal passant d'un premier état à un deuxième état et un procédé susceptible d'être mise en œuvre par un tel dispositif. Un tel signal trouve avantageusement application pour initialiser un circuit cible.

### ETAT DE LA TECHNIQUE

Certains circuits déclenchent des traitements sur réception d'un signal passant d'un premier état à un deuxième état, à la suite d'une mise sous tension. Ces traitements doivent être déclenchés rapidement à compter d'une telle mise sous tension.

Ainsi, lors d'une mise sous tension, un dispositif génère le signal en initialisant le signal dans le premier état, avant de basculer ce signal dans le deuxième état, et délivre ce signal à un circuit cible. Sur réception de ce signal, le circuit cible déclenche un traitement.

Toutefois, le dispositif délivrant le signal attendu par le circuit peut dysfonctionner, avec pour conséquence que le signal qu'il délivre ne contient pas la transition attendue du premier état vers le deuxième état. Par exemple, le signal peut être initialisé non pas dans le premier état, mais dans le deuxième état, ce qui retarde voire empêche le déclenchement du traitement censé être mis en œuvre par le circuit cible.

### EXPOSE DE L'INVENTION

Un but de l'invention est de proposer un dispositif délivrant un signal passant d'un premier état à un deuxième état, et ce d'une manière plus fiable.

Il est à cet effet proposé, selon un premier aspect, un dispositif pour délivrer un signal passant d'un premier état à un deuxième état, le dispositif comprenant un circuit primaire configuré pour générer un signal primaire, le signal primaire étant initialisé dans le premier état ou dans le deuxième état lors d'une mise sous tension du dispositif, le dispositif comprenant par ailleurs un circuit secondaire configuré pour :
- lorsque le signal primaire est initialisé dans le deuxième état lors de la mise sous tension, initialiser un premier compteur annulaire à une valeur aléatoire comprise dans une première séquence finie, la première séquence finie comprenant une première valeur de référence, et changer la valeur du premier compteur annulaire en parcourant la première séquence finie de manière circulaire,
- lorsque le signal primaire (por_ana) est initialisé dans le première état lors de la mise sous tension, initialiser le premier compteur annulaire (16) à la première valeur de référence (INIT),
- délivrer sur une sortie : i) un signal secondaire dans le premier état, lorsque la valeur du premier compteur est différente de la première valeur de référence, et ii) le signal primaire généré par le circuit primaire, lorsque la valeur du premier compteur est égale à la première valeur de référence.

Le dispositif selon le premier aspect peut en outre comprendre les caractéristiques optionnelles suivantes, prises seules ou combinées entre elles lorsque cela est techniquement possible.

De préférence, le circuit secondaire est configuré pour maintenir le premier compteur annulaire à la première valeur de référence, une fois que la première valeur de référence est atteinte par le premier compteur annulaire.

De préférence, la valeur du premier compteur annulaire est codée sur un nombre de bits supérieur ou égal à 16, par exemple 32.

De préférence, le circuit secondaire comprend une entrée d'horloge pour recevoir un signal d'horloge définissant des coups d'horloge, et est configuré pour changer la valeur du premier compteur annulaire à chaque coup d'horloge défini par le signal d'horloge reçu.

De préférence, le circuit primaire est configuré pour générer le signal d'horloge.

De préférence, le premier compteur annulaire est un compteur en cascade et/ou d'un des types suivants : incrémental, décrémental, Möbius, LFSR.

De préférence, le circuit secondaire est par ailleurs configuré pour :
- lors de la mise sous tension, initialiser un deuxième compteur annulaire à une valeur aléatoire comprise dans une deuxième séquence finie ayant une longueur inférieure à celle de la première séquence finie,
- changer la valeur du deuxième compteur annulaire en parcourant la deuxième séquence finie de manière circulaire,
- rapprocher la valeur du premier compteur annulaire de la première valeur de référence, lorsque le deuxième compteur atteint une deuxième valeur de référence comprise dans la deuxième séquence finie.

De préférence, le rapprochement est réalisé en ajustant le premier compteur annulaire à une valeur qui précède immédiatement la première valeur de référence dans la première séquence finie parcourue de manière circulaire.

De préférence, la valeur du deuxième compteur annulaire est codée sur un nombre de bits strictement supérieur à 1, par exemple 4 bits.

De préférence, le circuit secondaire est configuré pour changer la valeur du deuxième compteur annulaire à chaque coup d'horloge défini par le signal d'horloge reçu.

De préférence, le deuxième compteur annulaire est un compteur en cascade et/ou d'un des types suivants : incrémental, décrémental, Möbius, LFSR.

De préférence, le premier état est un état à zéro et le deuxième état est un état à un.

De préférence, le circuit secondaire est configuré pour générer le signal secondaire.

De préférence, le circuit primaire est configuré pour faire passer le signal primaire dans le premier état lors d'une mise hors tension du dispositif.

Il est également proposé, selon un deuxième aspect, un système comprenant un dispositif selon le premier aspect, et un circuit cible configuré pour mettre en œuvre un traitement prédéterminé sur réception du signal délivré par le dispositif selon le premier aspect, tel que s'initialiser.

Il est également proposé, selon un troisième aspect, un procédé pour délivrer un signal passant d'un premier état à un deuxième état, le procédé comprenant des étapes de :
- génération, par un circuit primaire, d'un signal primaire, le signal primaire étant initialisé dans le premier état ou dans le deuxième étant lors d'une mise sous tension du circuit primaire,
- lorsque le signal primaire est initialisé dans le deuxième état lors de la mise sous tension, initialisation d'un premier compteur annulaire à une valeur aléatoire comprise dans une première séquence finie comprenant une première valeur de référence, le premier compteur annulaire changeant de valeur en parcourant la première séquence finie de manière circulaire,
- lorsque le signal primaire (por_ana) est initialisé dans le première état lors de la mise sous tension, initialisation du premier compteur annulaire (16) à la première valeur de référence (INIT),
- délivrance sur une sortie : i) d'un signal secondaire dans le premier état, lorsque la valeur du premier compteur est différente de la première valeur de référence, et ii) du signal primaire généré par le circuit primaire, lorsque la valeur du premier compteur est égale à la première valeur de référence.

### DESCRIPTION DES FIGURES

D'autres caractéristiques, buts et avantages de l'invention ressortiront de la description qui suit, qui est purement illustrative et non limitative, et qui doit être lue en regard des dessins annexés sur lesquels :
[Fig. 1] La figure 1 illustre de façon schématique un système selon un mode de réalisation.
[Fig. 2] La figure 2 est un schéma-bloc illustratif d'un procédé mis en œuvre par le système de la figure 1.
[Fig. 3] La figure 3 montre l'évolution dans le temps d'un signal de tension d'alimentation, et celle d'un signal primaire passant d'un premier état vers un deuxième état.

Sur l'ensemble des figures, les éléments similaires portent des références identiques.

### DESCRIPTION DETAILLEE DE L'INVENTION

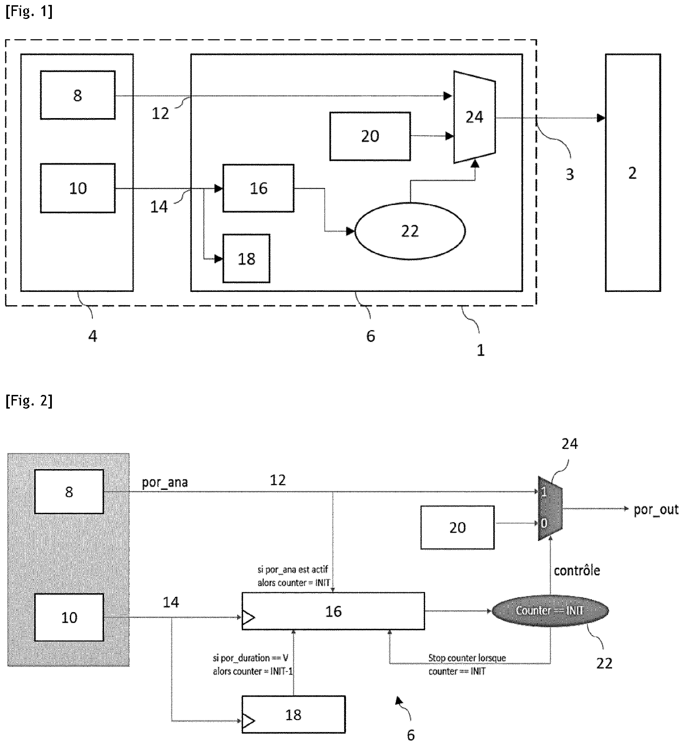

En référence à la **figure 1****,** un système, par exemple un système sur puce (SoC), comprend un dispositif 1 pour délivrer un signal passant d'un premier état à un deuxième état, suite à une mise sous tension du système, et un circuit cible 2 propre à recevoir ce signal.

Le circuit cible 2 est configuré pour mettre en œuvre un traitement prédéterminé sur réception de ce signal.

Le circuit cible 2 est un circuit numérique.

Par exemple, le premier état est un état à zéro, tandis que le deuxième état est un état à un. Dans ce cas, c'est lorsque le circuit cible 2 reçoit du dispositif 1 un signal passant de zéro à un, qu'il met en œuvre le traitement prédéterminé.

Par exemple, le traitement prédéterminé est une initialisation du circuit cible 2. Autrement dit, le circuit cible 2 est configuré pour s'initialiser sur réception du signal délivré par le dispositif 1, ce signal étant alors un signal d'initialisation.

Le dispositif 1 comprend une sortie 3 pour délivrer au circuit cible 2 le signal passant du premier état au deuxième état.

Le dispositif 1 d'initialisation comprend un circuit primaire 4 et un circuit secondaire 6.

Le circuit primaire 4 comprend un générateur primaire 8 pour générer un signal primaire à compter de la mise sous tension du système. Le signal primaire est susceptible de prendre le premier état et le deuxième état en alternance.

Plus précisément, le générateur primaire 8 est configuré pour générer le signal primaire en fonction d'une tension d'alimentation qui lui est appliquée par une source de tension électrique.

De préférence, le circuit primaire 4 comprend un étage d'entrée analogique mesurant la tension d'alimentation, et le générateur primaire 8 est un générateur numérique. Le signal primaire est donc dans ce cas numérique. En fait, le circuit primaire 4 joue le rôle d'un convertisseur analogique-numérique puisque dans ce cas un signal d'entrée analogique (la tension d'alimentation) est converti en un signal numérique (le signal primaire).

Le circuit primaire 4 comprend par ailleurs une horloge 10 configurée pour générer un signal d'horloge. Le signal d'horloge définit des coups d'horloge successifs, typiquement grâce à un motif périodique.

L'horloge 10 comprend typiquement un oscillateur.

Le circuit secondaire 6 comprend une entrée primaire 12 pour recevoir le signal primaire généré par le générateur primaire 8.

Le circuit secondaire 6 comprend par ailleurs une entrée d'horloge 14 pour recevoir le signal d'horloge généré par l'horloge 10.

Le circuit secondaire 6 est typiquement un circuit numérique.

Le circuit secondaire 6 comprend un premier compteur annulaire 16 (« ring counter » en anglais). L'ensemble des valeurs que peut prendre le premier compteur annulaire 16 définit une première séquence finie, c'est-à-dire que cet ensemble est ordonné. Le premier compteur annulaire 16 change de valeur en parcourant cette première séquence finie.

Le premier compteur annulaire 16 a une valeur qui est codée sur N bits. En conséquence, cette valeur peut prendre 2^{N} valeurs différentes.

Le premier compteur annulaire 16 change de valeur à chaque coup d'horloge défini par le signal d'horloge reçu par l'entrée d'horloge 14.

De préférence, N est supérieur ou égal à 16. Ceci présente l'avantage d'avoir la première séquence finie relativement grande. Par exemple, lorsque N=32, la première séquence finie est de longueur égale à 4294967296, c'est-à-dire que le premier compteur annulaire 16 est capable de prendre 4294967296 valeurs différentes.

Du fait de son caractère annulaire, le premier compteur annulaire 16 parcourt la première séquence finie de manière circulaire, c'est-à-dire que lorsque le premier compteur annulaire 16 atteint la fin de la première séquence finie, le premier compteur reboucle au début de cette séquence finie.

Par exemple, lorsque le premier compteur annulaire 16 est de type incrémental, la première séquence finie est croissante. Ainsi, la dernière valeur de la première séquence finie est une valeur maximale (typiquement la valeur 2^{N}-1), et le premier compteur annulaire 16 reboucle en une valeur minimale de cette séquence (typiquement la valeur zéro).

En variante, le premier compteur annulaire 16 est de type décrémental, auquel cas la première séquence finie est décroissante.

Dans d'autres variantes, le premier compteur annulaire 16 est de type Möbius, ou LFSR (« (Linear Feedback Shift Register, ou Registre à Décalage à Rebouclage Linéaire). Dans ces autres variantes, la première séquence finie n'est pas forcément parcourue de manière monotone. Utiliser en particulier un compteur de type Möbius présente l'avantage de ne requérir qu'une petite surface d'implémentation, car ne requiert que peu de logique.

Le premier compteur annulaire 16 est typiquement implémenté dans le circuit secondaire 6 à l'aide d'une pluralité de bascules interconnectées selon une disposition connue de l'homme du métier.

Le premier compteur est de préférence un compteur en cascade. Un compteur en cascade est un compteur à plusieurs étages, dans lequel la sortie d'un étage sert d'horlge pour un étage suivant. Ceci présente l'avantage de consommer moins d'énergie qu'un compteur synchrone.

La première séquence finie comprend notamment une valeur INIT, appelée dans la suite première valeur de référence.

Le circuit secondaire 6 est configuré pour initialiser le premier compteur annulaire 16 à une valeur de la première séquence finie, dite valeur initiale, selon une politique qui dépend de la manière dont le signal primaire généré par le générateur primaire 8 est initialisé lors d'une mise sous tension du système. Cette politique sera décrite plus loin en détail.

Le circuit secondaire 6 est par ailleurs configuré pour maintenir le premier compteur annulaire 16 dans la première valeur de référence INIT, une fois celle-ci atteinte. Autrement dit, le premier compteur annulaire 16 est stoppé une fois qu'il atteint la première valeur de référence INIT.

Le circuit secondaire 6 comprend par ailleurs un deuxième compteur annulaire 18. Comme le premier compteur annulaire 16, l'ensemble des valeurs que peut prendre le deuxième compteur annulaire 18 définit une deuxième séquence finie, c'est-à-dire que cet ensemble est ordonné.

Le deuxième compteur annulaire 18 a une valeur qui est codée sur M bits. En conséquence, cette valeur peut prendre 2^{M} valeurs différentes.

La deuxième séquence finie parcourue par le deuxième compteur annulaire 18 de manière circulaire est de longueur inférieure à celle de la première séquence finie. Autrement dit, on a M < N.

Le deuxième compteur annulaire 18 change avantageusement de valeur à chaque coup d'horloge défini par le signal d'horloge reçu par l'entrée d'horloge 14. Ceci est avantageux car permet de synchroniser les changements de valeurs des deux compteurs circulaires 16 et 18 plus simplement.

Le deuxième compteur annulaire 18 peut être de l'un des types envisagés ci-dessus pour le premier compteur annulaire 16. Le deuxième compteur annulaire 18 peut être de type identique ou différent de celui du premier compteur annulaire 16.

La deuxième séquence finie comprend notamment une valeur V, appelée dans la suite deuxième valeur de référence.

Le circuit secondaire 6 est configuré pour initialiser le premier compteur annulaire 16 à une valeur choisie aléatoirement dans la première séquence finie.

Le circuit secondaire 6 comprend par ailleurs un générateur secondaire 20 configuré pour générer un signal secondaire dans le premier état. Le générateur secondaire 20 est différent du générateur primaire 8.

Le circuit secondaire 6 comprend par ailleurs un comparateur 22 configuré pour comparer une valeur prise par le premier compteur annulaire 16 avec la première valeur de référence INIT.

Le circuit secondaire 6 comprend en outre un commutateur 24 relié au circuit primaire 4, relié au générateur secondaire 20, et par ailleurs relié à la sortie 3 du dispositif 1 d'initialisation. Le commutateur 24 est configurable dans deux configurations : une configuration primaire dans laquelle le commutateur 24 redirige sélectivement sur la sortie 3 du dispositif 1 d'initialisation le signal primaire généré par le générateur primaire 8, et une configuration secondaire dans laquelle le commutateur 24 redirige sélectivement sur la sortie 3 le signal secondaire généré par le générateur secondaire 20.

Comme cela sera détaillé plus loin, le commutateur 24 est configuré pour se placer dans l'une de ces deux configurations en fonction du résultat d'une comparaison mise en œuvre par le comparateur 22.

En référence à la **figure 2****,** un procédé mis en œuvre par le système décrit précédemment comprend les étapes suivantes.

Le système est mis sous tension à un instant donné. A partir de cet instant, une tension d'alimentation VDD est appliquée aux différents composants du système, notamment au circuit primaire 4.

Le générateur primaire 8 génère un signal primaire « por_ana » qui dépend de la tension d'alimentation appliquée.

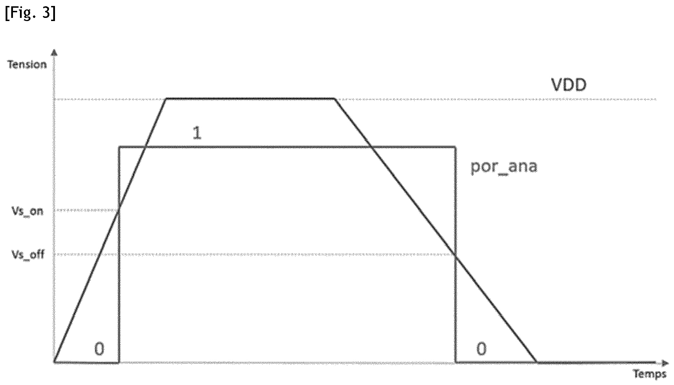

Dans un fonctionnement normal, la tension d'alimentation VDD appliquée au circuit primaire 4, initialement à zéro, croît progressivement, par exemple de manière linéaire dans l'exemple représenté en **figure 3****.**

Tant que la tension d'alimentation VDD appliquée au générateur primaire 8 reste inférieure à un seuil Vs_on, le signal primaire « por_ana » généré par le générateur primaire 8 est dans le premier état (état à zéro dans le cas représenté en figure 3). Lorsque la tension d'alimentation appliquée au générateur primaire 8 dépasse le seuil Vs_on, le signal primaire « por_ana » généré par le générateur primaire 8 bascule dans le deuxième état (état à un dans le cas représenté en figure 3).

Une logique inverse est mise en œuvre ultérieurement lors d'une mise hors tension du système, utilisant un autre seuil Vs_off. Lorsque le signal d'alimentation VDD descend en dessous de ce seuil Vs_off, le signal primaire « por_ana » repasse dans le premier état. Le seuil Vs_off est de préférence inférieur au seuil Vs_on.

De retour à la figure 2, l'horloge 10 génère le signal d'horloge décrit précédemment définissant des coups d'horloge successifs.

Le circuit secondaire 6 reçoit sur son entrée primaire 12 le signal primaire « por_ana » généré par le générateur primaire 8, et reçoit par ailleurs le signal d'horloge généré par l'horloge 10 sur son entrée d'horloge 14.

Le circuit secondaire 6 initialise à la mise sous tension le premier compteur annulaire 16 à une valeur initiale comprise dans la première séquence finie (sur la figure 2, la valeur courante prise par le premier compteur annulaire 16 est appelée « counter »).

La politique de sélection de la valeur initiale mise en œuvre par le circuit secondaire 6 dépend de l'état du signal primaire « por_ana » à la mise sous tension.

Quelle que soit cette politique, le comparateur 22 compare la valeur initiale du premier compteur annulaire 16 avec la première valeur de référence INIT.

Si les valeurs comparées par le comparateur 22 sont différentes, le commutateur 24 se place dans la configuration secondaire (désignée sur la figure 2 par la valeur 0 en bas à gauche du trapèze représentant le commutateur 24). Dans cette configuration secondaire, le commutateur 24 redirige sélectivement vers la sortie 3 du dispositif 1 d'initialisation le signal secondaire généré par le générateur secondaire 20, ce signal secondaire étant dans le premier état.

Si au contraire les valeurs comparées par le comparateur 22 sont égales, le commutateur 24 se place dans la configuration primaire, dans laquelle le commutateur 24 redirige sélectivement vers la sortie 3 du dispositif 1 d'initialisation le signal primaire « por_ana » généré par le générateur primaire 8 (sur la figure 2, la configuration primaire est désignée par la valeur 1 en haut à gauche du trapèze représentant le commutateur 24).

Au coup d'horloge suivant défini par le signal d'horloge, le circuit secondaire 6 met à jour le premier compteur annulaire 16 à la valeur qui suit la valeur initiale dans la première séquence finie, en parcourant cette séquence de manière circulaire.

Le comparateur 22 répète l'étape de comparaison suite à cette mise à jour, c'est-à-dire qu'il compare la valeur mise à jour du premier compteur annulaire 16 et la première valeur de référence INIT.

Si les valeurs comparées par le comparateur 22 lors de cette nouvelle comparaison sont différentes, le commutateur 24 reste dans la configuration secondaire, et continue donc à rediriger sélectivement vers la sortie 3 du dispositif 1 d'initialisation le signal secondaire dans le premier état, généré par le générateur secondaire 20.

Si au contraire les valeurs comparées par le comparateur 22 lors de cette nouvelle comparaison sont égales, le commutateur 24 bascule dans sa configuration primaire dans laquelle il redirige sélectivement vers la sortie 3 du dispositif 1 d'initialisation le signal primaire « por_ana » généré par le générateur primaire 8.

### Cas dans lequel le signal primaire est initialisé dans le premier état

Lorsque le circuit primaire 4 fonctionne normalement, le signal primaire « por_ana » est initialisé dans le premier état à la mise sous tension du système, puis bascule ultérieurement dans le deuxième état.

Lorsque le circuit secondaire 6 détecte que le signal primaire « por_ana » a été initialisé par le circuit primaire 4 dans le premier état, le circuit secondaire 6 initialise le premier compteur annulaire 16 à la première valeur de référence INIT, c'est-à-dire qu'il choisit de manière déterministe cette valeur INIT comme valeur initiale du premier compteur annulaire 16.

Ainsi, dans ce cas, le commutateur 24 commence forcément par rediriger vers la sortie 3 le signal primaire « por_ana ».

Par ailleurs, si le premier compteur annulaire 16 est configuré pour se maintenir à la première valeur de référence INIT une fois celle-ci atteinte, le commutateur 24 reste dans cette configuration primaire dans laquelle signal primaire « por_ana » est redirigé vers la sortie du dispositif d'initialisation.

Ultérieurement, lorsque le signal primaire « por_ana » passe du premier état au deuxième étant, cette transition est également redirigée vers la sortie.

Ainsi dans ce cas de fonctionnement normal, le signal « por_out » passant du premier état au deuxième état qui est *in fine* délivré au circuit cible 2 via la sortie 3 est formé par le signal primaire « por_ana » fourni par le circuit primaire 4. C'est donc le signal primaire « por_ana » fourni par le circuit primaire 4 qui permet à lui seul le déclenchement du traitement prédéterminé par le circuit cible 2.

### Cas dans lequel le signal primaire est initialisé dans le deuxième état

Lorsque le circuit primaire 4 fonctionne anormalement, le signal primaire « por_ana » peut, pour une raison inconnue, être initialisé par le circuit primaire 4 dans le deuxième état. Tant que cette situation perdure, le signal primaire « por_ana » n'est pas en mesure de déclencher le traitement prédéterminé du circuit cible 2. On va voir dans ce qui suit que le circuit secondaire 6 joue un rôle actif pour surmonter cette défaillance.

Lorsque le circuit secondaire 6 détecte que le signal primaire « por_ana » a été initialisé par le circuit primaire 4 dans le deuxième état, le circuit secondaire 6 initialise le premier compteur annulaire 16 à une valeur initiale choisie de manière aléatoire.

Si, par extraordinaire, cette valeur initiale choisie aléatoirement s'avère être la première valeur de référence INIT, le commutateur 24 se comporte comme décrit précédemment, c'est-à-dire qu'il redirige sélectivement le signal primaire « por_ana » sur la sortie, et se maintient dans cette configuration si le premier compteur annulaire 16 se maintient de son côté dans la valeur INIT, comme indiqué précédemment. Toutefois, la probabilité de tomber dans ce cas très spécifique est égale à 1/2^{N} ; cette probabilité décroit donc de manière exponentielle avec N. Cette probabilité est particulièrement faible lorsque N est supérieur ou égal à 16.

Si au contraire la valeur initiale sur laquelle le premier compteur annulaire 16 a été initialisé de manière aléatoire à la mise sous tension est différente de la première valeur de référence INIT (ce qui est probable), le comparateur 22 constate cette différence, et le commutateur 24, commence par rediriger sur la sortie le signal secondaire généré par le générateur secondaire 20, ce signal secondaire étant dans le premier état.

Après un certain nombre de coups d'horloge, qui dépend de la valeur initiale, le premier compteur annulaire 16 finit par atteindre la première valeur de référence INIT. Le comparateur 22 détecte alors une égalité de valeurs et le commutateur 24 redirige le signal primaire « por_ana » dans le deuxième état sur la sortie 3, en lieu et place du signal secondaire, en basculant de la configuration secondaire à la configuration primaire.

Ainsi, dans le cas où le signal primaire « por_ana » est initialisé dans le deuxième état à la mise sous tension, cette situation anormale est palliée par le circuit secondaire 6, qui joue un rôle actif pour crée une transition du premier état vers le deuxième état qui est vue par le circuit cible 2, grâce à la bascule réalisée par le commutateur 24 à l'aide du premier compteur annulaire 16. Le circuit secondaire 6 a donc pour effet de pouvoir faire en sorte que le circuit cible 2 obtienne un signal « por_out » passant du premier état vers le deuxième état, même si le signal primaire « por_ana » ne contient pas cette transition d'état. Ce signal « por_out » délivré sur la sortie 3 est ici formé par une combinaison du signal primaire « por_ana » et du signal secondaire.

Il est à remarquer ici que, même si le circuit primaire 4 est défaillant, celui-ci participe tout de même à la formation de la transition allant du premier état vers le deuxième état qui est perçue par le circuit cible 2, puisque le circuit secondaire 6 redirige le signal primaire « por_ana » dans le deuxième état après avoir basculé de la configuration secondaire vers la configuration secondaire. Ceci présente plusieurs avantages.

Premièrement, ceci permet au circuit cible de détecter un retour ultérieur du signal primaire « por_ana » dans le premier état, lors d'une chute de la tension d'alimentation appliquée au générateur primaire 8, ce retour ayant tendance à se produire même dans le cas de défaillance susmentionné dans lequel le signal « por_ana » est initialisé dans le deuxième état. En effet, ce retour dans le premier état est retranscrit dans le signal de sortie « por_out » lorsque le commutateur est dans la configuration primaire.

Deuxièmement, la probabilité de non obtention de transition du premier état vers le deuxième état dans le signal « por_ou » fourni par le dispositif 1 est égale le produit de de la probabilité de défaillance de du circuit primaire multipliée par la probabilité que le premier compteur annulaire 16 s'initialise à INIT. Cette probabilité de non obtention est réduite par rapport à un fonctionnement autonome du circuit secondaire seul.

Il est à remarquer que le maintien du premier compteur annulaire 16 à la première valeur de référence INIT une fois celle-ci atteinte est, bien qu'optionnel, très avantageux. En effet, ce maintien permet d'éviter que le commutateur 24 ne rebascule de la configuration primaire à la configuration secondaire au coup d'horloge suivant. Si cela se produit, le signal « por_out » délivré au circuit cible 2 via la sortie 3 ne reste dans le deuxième état que pendant un intervalle de temps très fugace, et est donc susceptible de ne pas être correctement détecté par le circuit cible 2 si bien que le traitement prédéterminé pourrait ne pas être déclenché par le circuit cible 2.

### Utilisation du deuxième compteur annulaire 18 pour réduire le délai d'obtention d'un signal passant du premier état au deuxième état

Le circuit secondaire 6 initialise par ailleurs le deuxième compteur annulaire 18 à une valeur initiale choisie aléatoirement dans la deuxième séquence finie, lors de la mise sous tension du système.

Cette initialisation est mise en œuvre lorsque le circuit secondaire 6 détecte que le signal primaire « por_ana » a été initialisé par le circuit primaire 4 dans le deuxième état (cas de fonctionnement anormal).

A chaque nouveau coup d'horloge défini par le signal d'horloge, le circuit secondaire 6 met à jour le deuxième compteur annulaire 18 à la valeur suivante de la deuxième séquence finie, de manière circulaire. Sur la figure 2, la valeur courante prise par le deuxième compteur annulaire 18 est appelée « por_duration ».

Lorsque le deuxième compteur annulaire 18 atteint la deuxième valeur de référence V, le circuit secondaire 6 rapproche la valeur du premier compteur annulaire 16 de la première valeur de référence INIT. Ceci permet ainsi de faire en sorte que le premier compteur annulaire 16 atteigne plus rapidement la valeur INIT, donc de faire basculer le commutateur 24 de la configuration secondaire vers la configuration primaire plus rapidement, et par voie de conséquence de créer une transition du premier état vers le deuxième état sur la sortie 3 du dispositif 1 d'initialisation. Le circuit cible 2 s'initialise donc plus rapidement, en recevant le signal « por_out » fourni par le dispositif 1 via sa sortie 3.

On notera à cet égard que la probabilité pour que le deuxième compteur annulaire 18 atteigne la valeur V avant que le premier compteur annulaire 16 atteint la valeur INIT est élevée, car la longueur de la première séquence finie est supérieure à celle de la deuxième séquence finie.

De manière très avantageuse, le rapprochement réalisé par le deuxième compteur annulaire 18 ajuste le premier compteur annulaire 16 à une valeur que prend le premier compteur annulaire 16 juste avant d'atteindre la première valeur de référence INIT en parcourant la première séquence finie de manière circulaire, c'est-à-dire à une valeur qui précède immédiatement INIT dans la séquence finie parcourue circulairement.

Par exemple, si le premier compteur annulaire 16 est de type incrémental, avec une première séquence finie allant de 0 à 2^{N}-1, cette valeur immédiatement précédente vaut 2^{N}-1 dans le cas particulier où INIT = 0 (ceci résulte du caractère annulaire du compteur) et vaut INIT-1 dans tous les autres cas.

Ainsi, il ne suffit que d'un coup d'horloge pour que la première valeur de référence INIT ne soit atteinte par le premier compteur annulaire 16.

De préférence, le deuxième compteur annulaire n'est pas utilisé, lorsque le circuit secondaire 6 détecte que le signal primaire « por_ana » a été initialisé par le circuit primaire 4 dans le premier état (cas de fonctionnement normal)

### Autres variantes de réalisation

Le système et le procédé tels que définis ci-dessus peuvent faire l'objet d'autres variantes.

Le signal « por_out » délivré par le dispositif 1 au circuit cible 2 peut avoir une autre fonction que celle consistant à déclencher une initialisation du circuit cible 2.

Par ailleurs, le premier état n'est pas forcément un état à zéro et le deuxième état un état à un. Par exemple, ces deux valeurs peuvent être inversées.

L'horloge 10 n'est pas forcément partie intégrante du circuit primaire 4 (même si une telle inclusion dans le circuit primaire 4 présente des avantages en termes de sécurisation du système contre des attaques qui viseraient à prendre le contrôle du système en injectant des formes de signaux inadéquates sur l'entrée d'horloge, dans le cas où celle-ci proviendrait d'une circuiterie externe au dispositif 1).

## Revendications

1. Dispositif (1) pour délivrer un signal (por_out) passant d'un premier état à un deuxième état, le dispositif (1) comprenant un circuit primaire (4) configuré pour générer un signal primaire (por_ana), le signal primaire (por_ana) étant initialisé dans le premier état ou dans le deuxième état lors d'une mise sous tension du dispositif (1), le dispositif (1) comprenant par ailleurs un circuit secondaire (6) configuré pour :
- lorsque le signal primaire (por_ana) est initialisé dans le deuxième état lors de la mise sous tension, initialiser un premier compteur annulaire (16) à une valeur aléatoire comprise dans une première séquence finie, la première séquence finie comprenant une première valeur de référence (INIT), et changer la valeur du premier compteur annulaire (16) en parcourant la première séquence finie de manière circulaire,
- lorsque le signal primaire (por_ana) est initialisé dans le première état lors de la mise sous tension, initialiser le premier compteur annulaire (16) à la première valeur de référence (INIT),
- délivrer sur une sortie (3) : i) un signal secondaire dans le premier état, lorsque la valeur du premier compteur est différente de la première valeur de référence (INIT), et ii) le signal primaire (por_ana) généré par le circuit primaire (4), lorsque la valeur du premier compteur est égale à la première valeur de référence (INIT).

2. Dispositif (1) selon la revendication précédente, dans lequel le circuit secondaire (6) est configuré pour maintenir le premier compteur annulaire (16) à la première valeur de référence, une fois que la première valeur de référence est atteinte par le premier compteur annulaire (16).

3. Dispositif (1) selon l'une des revendications précédentes, dans lequel la valeur du premier compteur annulaire (16) est codée sur un nombre de bits supérieur ou égal à 16, par exemple 32.

4. Dispositif (1) selon l'une des revendications précédentes, dans lequel le circuit secondaire (6) comprend une entrée d'horloge (14) pour recevoir un signal d'horloge définissant des coups d'horloge, et est configuré pour changer la valeur du premier compteur annulaire (16) à chaque coup d'horloge défini par le signal d'horloge reçu.

5. Dispositif (1) selon la revendication précédente, dans lequel le circuit primaire (4) est configuré pour générer le signal d'horloge.

6. Dispositif (1) selon l'une des revendications précédentes, dans lequel le premier compteur annulaire (16) est un compteur en cascade et/ou d'un des types suivants : incrémental, décrémental, Möbius, LFSR.

7. Dispositif (1) selon l'une des revendications précédentes, dans lequel le circuit secondaire (6) est par ailleurs configuré pour :
- lors de la mise sous tension, initialiser un deuxième compteur annulaire (18) à une valeur aléatoire comprise dans une deuxième séquence finie ayant une longueur inférieure à celle de la première séquence finie,
- changer la valeur du deuxième compteur annulaire (18) en parcourant la deuxième séquence finie de manière circulaire,
- rapprocher la valeur du premier compteur annulaire (16) de la première valeur de référence (INIT), lorsque le deuxième compteur atteint une deuxième valeur de référence (V) comprise dans la deuxième séquence finie.

8. Dispositif (1) selon la revendication précédente, dans lequel le rapprochement est réalisé en ajustant le premier compteur annulaire (16) à une valeur qui précède immédiatement la première valeur de référence (INIT) dans la première séquence finie parcourue de manière circulaire.

9. Dispositif (1) selon l'une des revendications 7 et 8, dans lequel la valeur du deuxième compteur annulaire (18) est codée sur un nombre de bits strictement supérieur à 1, par exemple 4 bits.

10. Dispositif (1) l'une des revendications 7 à 9 dans leur dépendance à l'une des revendication 5 et 6, dans lequel le circuit secondaire (6) est configuré pour changer la valeur du deuxième compteur annulaire (18) à chaque coup d'horloge défini par le signal d'horloge reçu.

11. Dispositif (1) selon l'une des revendications précédentes, dans lequel le premier état est un état à zéro et le deuxième état est un état à un.

12. Dispositif (1) selon l'une des revendications précédentes, dans lequel le circuit secondaire (6) est configuré pour générer le signal secondaire.

13. Dispositif (1) selon l'une des revendications précédentes, dans lequel le circuit primaire (4) est configuré pour faire passer le signal primaire dans le premier état lors d'une mise hors tension du dispositif (1).

14. Système comprenant un dispositif (1) selon l'une des revendications précédentes, et un circuit cible (2) configuré pour mettre en œuvre un traitement prédéterminé sur réception du signal (por_out) délivré par le dispositif (1), tel que s'initialiser.

15. Procédé pour délivrer un signal (por_out) passant d'un premier état (0) à un deuxième état (1), le procédé comprenant des étapes de :
- génération, par un circuit primaire (4), d'un signal primaire (por_ana), le signal primaire (por_ana) étant initialisé dans le premier état ou dans le deuxième étant lors d'une mise sous tension du circuit primaire (4),
- lorsque le signal primaire (por_ana) est initialisé dans le deuxième état lors de la mise sous tension, initialisation d'un premier compteur annulaire (16) à une valeur aléatoire comprise dans une première séquence finie comprenant une première valeur de référence (INIT), le premier compteur annulaire (16) changeant de valeur en parcourant la première séquence finie de manière circulaire,
- lorsque le signal primaire (por_ana) est initialisé dans le première état lors de la mise sous tension, initialisation du premier compteur annulaire (16) à la première valeur de référence (INIT),
- délivrance sur une sortie (3) : i) d'un signal secondaire dans le premier état, lorsque la valeur du premier compteur est différente de la première valeur de référence (INIT), et ii) du signal primaire (por_ana) généré par le circuit primaire (4), lorsque la valeur du premier compteur est égale à la première valeur de référence (INIT).
